# EUROPEAN PATENT APPLICATION

(11) **EP 4 697 599 A1**
(43) Date of publication of application: **18.02.2026**
(21) Application number: 25192337.1
(22) Date of filing: 29.07.2025
(51) Int. Cl.: H03K 3/356

(54) **LEVEL SHIFTING CIRCUIT**

(30) Priority: 12.08.2024 US 202418800854
(71) Applicant: STMicroelectronics International N.V., 1228 Plan-les-Ouates, Geneva (CH)
(72) Inventor: JOUANNEAU, Thomas, 38560 JARRIE (FR)
(74) Representative: Casalonga

(57) **Abstract**

A level shifter circuit is disclosed. The level shifter includes an input circuit including a plurality of low voltage threshold switches and configured to receive an input voltage and to generate a second voltage, where the second voltage varies between a first low voltage and a first high voltage; an output circuit including a first plurality of high voltage switches and configured to receive the second voltage and to generate a third voltage, where the third voltage varies between the first low voltage and a second high voltage; and a buffer circuit , the buffer circuit being configured to receive the third voltage and to generate a buffer circuit output voltage, where the buffer circuit output voltage varies between a second low voltage and the second high voltage.

## Description

### TECHNICAL FIELD

The present disclosure generally relates to a level shifting circuit, as well as to methods for level shifting signals.

### BACKGROUND

Some electronic systems benefit from level shifter circuits. For example, some electronic systems have a digital control circuit, such as a processor or a controller, which generates output signals having a lower voltage range (e.g., 0 V - 1 V), where the other circuit uses input signals having a higher voltage range (e.g., 0 V - 5 V). These types of electronic systems may use level shifter circuits to convert lower voltage range output signals from the controller to higher voltage range input signals for the other circuit.

### SUMMARY

One embodiment is a level shifter circuit, including an input circuit including a plurality of low voltage threshold switches and configured to receive an input voltage and to generate a second voltage, where the second voltage varies between a first low voltage and a first high voltage; an output circuit including a first plurality of high voltage switches and configured to receive the second voltage and to generate a third voltage, where the third voltage varies between the first low voltage and a second high voltage; and a buffer circuit , the buffer circuit being configured to receive the third voltage and to generate a buffer circuit output voltage, where the buffer circuit output voltage varies between a second low voltage and the second high voltage.

Another embodiment is an array circuit, including an array of devices, where a plurality of devices of the array each include at least one high voltage switch; a controller configured to generate a plurality of first control signals for controlling the array of devices; and an array of level shifters, each level shifter configured to receive one of the first control signals from the controller as an input voltage, to generate one of a plurality of second control signals as a level shifter output voltage, and to provide the level shifter output voltage to one of the devices of the array of devices, where the level shifters each include an input circuit including a plurality of low voltage threshold switches and configured to generate a second voltage, where the second voltage varies between a first low voltage and a first high voltage; an output circuit including a first plurality of high voltage switches and configured to receive the second voltage and to generate a third voltage, where the third voltage varies between the first low voltage and a second high voltage; and a buffer circuit, the buffer circuit configured to receive the third voltage and to generate a buffer circuit output voltage, where the buffer circuit output voltage varies between a second low voltage and the second high voltage.

Another embodiment is a method of using a level shifter circuit, the method including with an input circuit including a plurality of low voltage threshold switches receiving an input voltage, and generating a second voltage based in part on the input voltage, where the second voltage varies between a first low voltage and a first high voltage; with an output circuit including a plurality of high voltage switches receiving the second voltage, and generating a third voltage based on the second voltage, where the third voltage varies between the first low voltage and a second high voltage; and with a buffer circuit receiving the third voltage, and generating an output voltage based on the third voltage, where the output voltage varies between a second low voltage and the second high voltage.

### BRIEF DESCRIPTION OF THE DRAWINGS

For a more complete understanding of one or more embodiments of the present disclosure, and the advantages thereof, reference is now made to the following descriptions taken in conjunction with the accompanying drawings, in which:
Figure 1 shows a schematic circuit diagram of an electronic system according to some embodiments;
Figure 2 shows a block diagram of a level shifter circuit according to some embodiments;
Figure 3 shows a schematic circuit diagram of a level shifter circuit according to some embodiments;
Figure 4 shows a schematic circuit diagram of a level shifter circuit according to some embodiments;
Figure 5 shows a schematic circuit diagram of a level shifter circuit according to some embodiments;
Figure 6 shows a schematic circuit diagram of an electronic system according to some embodiments;
Figure 7 shows a schematic circuit diagram of buffer circuit according to some embodiments;
Figure 8 shows a schematic circuit diagram of an electronic system according to some embodiments; and
Figure 9 shows a flowchart diagram of a method of using an electronic system according to some embodiments.

Corresponding numerals and symbols in the different figures generally refer to corresponding parts unless otherwise indicated. The figures are drawn to illustrate the relevant aspects of the embodiments and are not necessarily drawn to scale. The edges of features drawn in the figures do not necessarily indicate the termination of the extent of the feature.

### DETAILED DESCRIPTION OF ILLUSTRATIVE EMBODIMENTS

Illustrative embodiments of the system and method of the present disclosure are described below. In the interest of clarity, all features of an actual implementation may not be described in this specification. It will of course be appreciated that in the development of any such actual embodiment, numerous implementation-specific decisions may be made to achieve the developer's specific goals, such as compliance with system-related and business-related constraints, which will vary from one implementation to another. Moreover, it should be appreciated that such a development effort might be complex and time-consuming but would nevertheless be a routine undertaking for those of ordinary skill in the art having the benefit of this disclosure.

Reference may be made herein to the spatial relationships between various components and to the spatial orientation of various aspects of components as the devices are depicted in the attached drawings. However, as will be recognized by those skilled in the art after a complete reading of the present disclosure, the devices, members, apparatuses, etc. described herein may be positioned in any desired orientation. Thus, the use of terms such as "above," "below," "upper," "lower," or other like terms to describe a spatial relationship between various components or to describe the spatial orientation of aspects of such components should be understood to describe a relative relationship between the components or a spatial orientation of aspects of such components, respectively, as the device described herein may be oriented in any desired direction.

The making and using of various embodiments are discussed in detail below. It should be appreciated, however, that the various embodiments described herein are applicable in a wide variety of specific contexts. The specific embodiments discussed are merely illustrative of specific ways to make and use various embodiments, and should not be construed in a limited scope.

The embodiments discussed herein illustrate various aspects of level shifter circuit technology which use minimal die area to implement, and which provide accurate, fast, and low power level shifting of signals.

High voltage logic signals are often needed to control a circuit, such as a non-volatile memory array, which may typically be found, for example, in general purpose microcontrollers or pixel arrays, which are found, for example, in image sensor circuits. A large numbers of high voltage signals (e.g., > 4 V or about 5 V) may be controlled with low voltages signals (e.g., 1 V). Voltage translation may be done by level shifter circuits, which are placed with in large numbers according to the number of signals to control. The discussed embodiments use small amounts of area so that the overall system size is reduced.

Some manufacturing processes have options for forming switches, such as MOSFETs, or other transistors of different types. For example, a manufacturing process may have low voltage switches, medium voltage switches, and high voltage switches. In various embodiments, a low voltage transistor operates at 40% to 80% of the operational Vds/Vgs of the medium voltage transistor, which operates at 40% to 80% of the operational Vds/Vgs of the high voltage transistor. The threshold voltage of the medium voltage transistor is about 1.5x to 2.5x of the threshold voltage of the low voltage transistor while the threshold voltage of the high voltage transistor is about 3x to 5x of the threshold voltage of the medium voltage transistor. In some embodiments, the low voltage switches have about 1 V Vds and Vgs maximum voltage allowed, the medium voltage switches have about 2 V Vds and Vgs maximum voltage allowed, and the high voltage switches have greater than about 4 VVds and Vgs maximum voltage allowed. In some embodiments, the gate turn on threshold of the low voltage switches is about 0.2 V or 0.3 V. In some embodiments, the gate turn on threshold of the medium voltage switches is about 0.4 V. In some embodiments, the gate turn on threshold of the high voltage switches is about 0.6 V or 0.7 V. In some embodiments, the low voltage switches use less area than the medium voltage switches, and the medium voltage switches use less area than the high voltage switches.

Logic signal voltage level shifting from low voltage (typ. 1 V) input to a high voltage (>4 V or about 5 V typ.) output, generally causes voltages across low voltage switches to exceed their maximum voltage tolerance thresholds. Particular level shifter architectures may be used to ensure correct functionality while protecting protect individual transistors from overvoltage stressing. The functionality may be described as generating an output signal that varies over a desired output voltage level range based on input signals varying over a particular input voltage level range, where the output signals preserve the input signal encoding, such that logic 0 input signals cause logic 0 output signals to be generated and logic 1 input signals cause logic 1 output signals to be generated.

Sometimes, protection of individual transistors can be accomplished by careful design to ensure they are not exposed to voltages or current greater than their allowed limits so that products are functional throughout the life of the product.

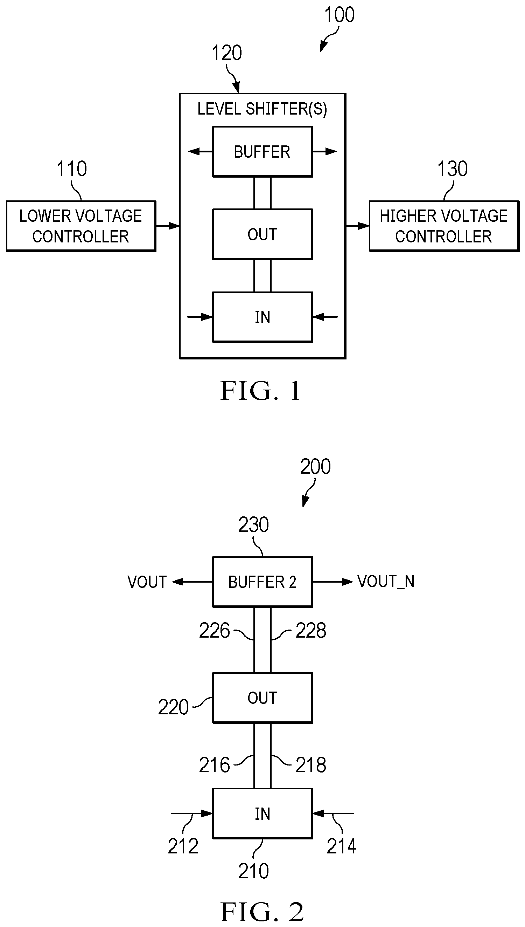

Figure 1 shows a schematic circuit diagram of an electronic system 100 according to some embodiments. Electronic system 100 includes a controller 110, level shifting circuit 120, and controlled circuit 130.

Controller 110 generates control signals for controlled circuit 130 using, for example, low voltage switches, where the control signals generated by controller 110 have a lower level voltage range, such as from 0 V to 1 V, or another voltage range. In some embodiments, controller 110 is or includes a controller or processor for a system including an array of devices, such as a memory, a display, or an image capture device.

Controlled circuit 130 performs its functions using circuits having, for example, high voltage switches which generate signals having a higher voltage range, such as from 0 V to 5 V, or another voltage range. In addition, controlled circuit 130 generates the signals in response to input control signals having the higher voltage range. In some embodiments, controlled circuit 130 includes an array of unit cell devices, such as for an array of memory cells, an array of display cells, or an array of image capture cells.

Level shifting circuit 120 includes one or more level shifter circuits, examples of which are described in more detail below. The level shifting circuit 120 receives the lower voltage control signals from controller 110 and generates the higher voltage control signals for controlled circuit 130.

Figure 2 shows a block diagram of a level shifter circuit 200 according to some embodiments. Level shifter circuit 200 may be used in or as level shifting circuit 120. For example, level shifting circuit 120 may include an embodiment of level shifter circuit 200 for each of a number of control signals generated by controller 110 for controlled circuit 130. Accordingly, in some embodiments, level shifter circuit 200 may include many instances of a level shifter circuit such as level shifter circuit 200. Level shifter circuit 200 includes input circuit 210, output circuit 220, and buffer circuit 230.

In the illustrated embodiment of level shifter circuit 200, each component receives a differential input signal, and generates a differential output signal. In some embodiments, one or more or all components of level shifter circuit 200 receives a single ended input signal. In some embodiments, one or more or all components of level shifter circuit 200 generates a single ended output signal. In some embodiments, one or more or all components of level shifter circuit 200 receives a single ended input and generates a single ended output signal. In some embodiments, one or more or all components of level shifter circuit 200 receives a single ended input signal and generates a differential output signal.

Input circuit 210 includes switches which receive an input signal at input nodes 212 and 214 from, for example, a controller, such as controller 110. In some embodiments, the switches of input circuit 210 include low voltage switches. In some embodiments, the switches of input circuit 210 include medium voltage switches. In some embodiments, the switches of input circuit 210 include high voltage switches.

The input signal at input nodes 212 and 214 may have a lower level voltage range, such as from 0 V to 1 V, or another voltage range. Based on the input signal, input circuit 210 generates signals for output circuit 220 at nodes 216 and 218, where the signals for output circuit 220 may also have the lower level voltage range. In some embodiments, the signals for the output circuit 220 have a different voltage range.

In some embodiments, input circuit 210 is inverting, such that the output signal and the input signal have opposite polarity. In some embodiments, input circuit 210 is noninverting, such that the input signal and the output signal have the same polarity.

Output circuit 220 includes switches which receive an input signal at input nodes 216 and 218 from input circuit 210. In some embodiments, the switches of output circuit 220 include low voltage switches. In some embodiments, the switches of output circuit 220 include medium voltage switches. In some embodiments, the switches of output circuit 220 include high voltage switches.

The input signal at nodes 216 and 218 may have a lower level voltage range, such as from 0 V to 1V, or another voltage range. Based on the input signal at nodes 216 and 218, output circuit 220 generates signals for buffer circuit 230 at nodes 226 and 228, where the signals for buffer circuit 230 may have a voltage range different from the lower level voltage range. For example, the signals for the buffer circuit 230 may have a range greater than the lower level voltage range. In some embodiments, the signals for the buffer circuit 230 have a second voltage range, such as from 0 V to 4 V, 0 V to 5 V, or another voltage range.

In some embodiments, output circuit 220 is inverting, such that the output signal and the input signal have opposite polarity. In some embodiments, output circuit 220 is noninverting, such that the input signal and the output signal have the same polarity.

Buffer circuit 230 includes switches which receive an input signal at input nodes 226 and 228 from output circuit 220. In some embodiments, the switches of buffer circuit 230 include low voltage switches. In some embodiments, the switches of buffer circuit 230 include medium voltage switches. In some embodiments, the switches of buffer circuit 230 include high voltage switches.

Based on the input signal at nodes 226 and 228, buffer circuit 230 generates the output signals of level shifter circuit 200 at output nodes VOUT and VOUT_N. The output signals for level shifter circuit 200 may have a voltage range which is the same as the voltage range of the input signal at nodes 226 and 228. In some embodiments, the output signals for the level shifter circuit 200 have a voltage range from 0 V to 5 V, or another voltage range.

In some embodiments, buffer circuit 230 is inverting, such that the output signal and the input signal have opposite polarity. In some embodiments, buffer circuit 230 is noninverting, such that the input signal and the output signal have the same polarity.

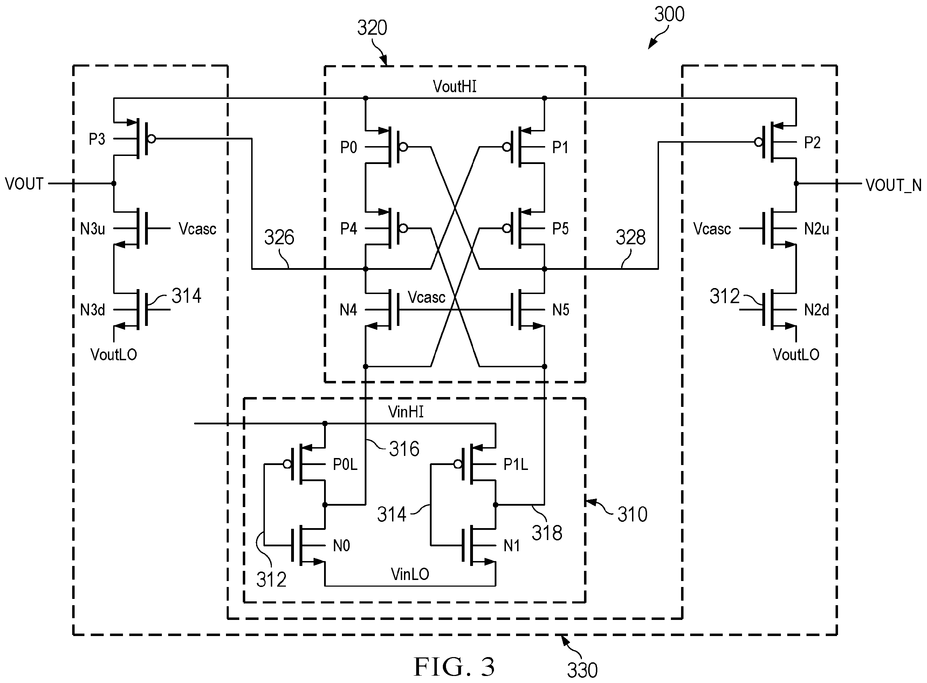

Figure 3 shows a schematic circuit diagram of a level shifter circuit 300 according to some embodiments. Level shifter circuit 300 is a nonlimiting example of level shifter circuit 200, and includes input circuit 310, output circuit 320, and buffer circuit 330.

Input circuit 310 includes switches which receive an input signal at input nodes 312 and 314 from, for example, a controller, such as controller 110. In alternative embodiments, node 316 is connected to node 314, and the input signal from the controller is single ended. In the illustrated embodiment, the switches of input circuit 310 are low voltage switches.

The input signal at nodes 312 and 314 may have a first voltage range, between voltage VinLo and voltage VinHI, such as from 0 V to 1 V, or another voltage range. Based on the input signal, input circuit 310 generates signals for output circuit 320 at nodes 316 and 318, where the signals for output circuit 320 may also have the first voltage range. In some embodiments, the signals for the output circuit 320 have a different voltage range.

In some embodiments, input circuit 310 is inverting, such that the output signal and the input signal have opposite polarity. In some embodiments, input circuit 310 is noninverting, such that the input signal and the output signal have the same polarity.

Output circuit 320 includes switches which receive an input signal at input nodes 316 and 318 from input circuit 310. In some embodiments, the switches of output circuit 320 include low voltage switches. In some embodiments, the switches of output circuit 320 include medium voltage switches. In some embodiments, the switches of output circuit 320 include high voltage switches. In some embodiments, all of the switches of output circuit 320 are high voltage switches.

In the illustrated embodiment, the input signal at nodes 316 and 318 may have the first voltage range, such as from 0 V to 1 V, or another voltage range. Based on the input signal at nodes 316 and 318, output circuit 320 generates signals for buffer circuit 330 at nodes 326 and 328, where the signals for buffer circuit 330 may have a second voltage range between voltage VinLO and voltage VoutHI, which is different from the first voltage range. For example, the signals for the buffer circuit 330 may have a range greater than the first voltage range, such as from 0 V to 4 V or 5 V, or another voltage range.

In some embodiments, output circuit 320 is inverting, such that the output signal and the input signal have opposite polarity. In some embodiments, output circuit 320 is noninverting, such that the input signal and the output signal have the same polarity.

Buffer circuit 330 includes switches which receive an input signal at input nodes 326 and 328 from output circuit 320. In some embodiments, the switches of buffer circuit 330 include low voltage switches. In some embodiments, the switches of buffer circuit 330 include medium voltage switches. In some embodiments, the switches of buffer circuit 330 include high voltage switches. In some embodiments, all of the switches of buffer circuit 330 are high voltage switches. In the illustrated embodiment, switches P3, N3u, P2, Nd N2u are high voltage switches, and switches N3d and N2d are low voltage switches.

Based on the input signal at nodes 326 and 328, buffer circuit 330 generates the output signals of level shifter circuit 300 at output nodes VOUT and VOUT_N. The output signals for level shifter circuit 300 may have a third voltage range between voltage VoutLO and voltage VoutHI. In some embodiments, the output signals for the level shifter circuit 300 have a voltage range from 0 V to 5 V, or another voltage range. In some embodiments, the output signals for level shifter circuit 300 may have another voltage range which is different from the voltage range of the input signal at nodes 326 and 328.

In some embodiments, buffer circuit 330 is inverting, such that the output signal and the input signal have opposite polarity. In some embodiments, buffer circuit 330 is noninverting, such that the input signal and the output signal have the same polarity.

The following examples of configurations and relationships between various voltages may be used, for example, to ensure or maximize functionality while preventing or minimizing voltage stress or overstress of the various transistors.

In some embodiments, high voltage switches N2u, N3u, N4, and N5 experience drain to source voltages which are limited to being less than 5 v. In some embodiments, high voltage switches N2u, N3u, N4, and N5 experience drain to source voltages which are limited to VoutHI (e.g. 5 V) - VinHI (e.g. 1 V).

In some embodiments, high voltage switches N2u, N3u, N4, and N5 experience drain to source voltages which are limited to VoutHI (e.g. 5 V) - VinHI (e.g. 1 V).

In some embodiments, high voltage switches P0, P1, P2, P3, P4, and P5 experience drain to source voltages which are up to VoutHI (e.g. 5 V) - VoutLO (e.g. 0 V). This may be appropriately less than a specified maximum drain to source voltages for the P-type switches.

This architecture is particularly advantageous when used for circuits manufactured with processing technologies in which the maximum drain to source voltage is greater for P-type switches than for N-type switches.

In some embodiments, the cascode voltage Vcasc is equal to the voltage VinHI. In some embodiments, the cascode voltage Vcasc is less than the voltage VinHI + the Vgs threshold voltages of cascode switches N4 and N5, for example, to limit leakage. In some embodiments, the cascode voltage Vcasc is greater than the voltage VinLO + the Vgs threshold voltages of switches N2d and N3d + an overdrive margin voltage for switches N2d and N3d. In some embodiments, the overdrive margin voltage is sufficient to cause switches N2d and N3d to be conductive enough to discharge output nodes VOUT and VOUT_N.

In some embodiments, voltage VoutLO is equal to voltage VinLO. In some embodiments, voltage VoutLO is greater than voltage VinLO.

In some embodiments, the gate of switch N3d is not connected to node 314 and is connected to node 316. In some embodiments, the gate of switch N2d is not connected to node 312 and is connected to node 318.

In some embodiments, the gate of switch N3d is driven by a delay element receiving either node 314 or 316 as an input. The delay may be designed to be sufficient that the switch N3d is not on while switch P3 is on. In some embodiments, the gate of switch N2d is driven by a delay element receiving either node 312 or 318 as an input. The delay may be designed to be sufficient that the switch N2d is not on while switch P2 is on.

In some embodiments, switches PoL and P1L are omitted. This has an advantage, for example, that the level shifter may be smaller and may use less power. When used, switches PoL and P1L increase speed by increasing the voltages at nodes 316 and 318. In embodiments with switches PoL and P1L omitted, leakage from voltage VinHI to voltage VoutHI through cascode switches N4 and N5 may be avoided.

In some embodiments, switches P4 and P5 are omitted. This has an advantage, for example, that the level shifter may be smaller and may use less power. In some embodiments, using switches P4 and P5 may, for example, improve speed.

In some embodiments, one of outputs VOUT and VOUT_N is not needed, and either switches P3, N3u, and N3d are omitted or switches P2, N2u, and N2d are omitted, for example, to save area and improve speed.

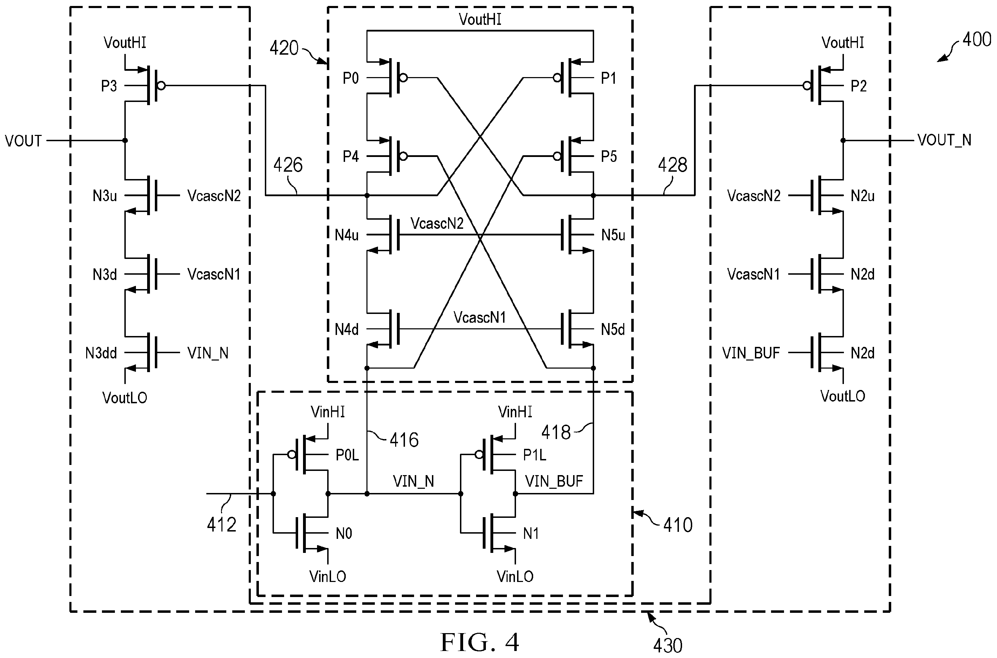

Figure 4 shows a schematic circuit diagram of a level shifter circuit 400 according to some embodiments. Level shifter circuit 400 is a nonlimiting example of level shifter circuit 200, and includes input circuit 410, output circuit 420, and buffer circuit 430. Unless otherwise specified or understood, level shifter circuit 400 has features similar or identical to those of level shifter circuit 300.

Input circuit 410 includes switches which receive an input signal at input node 412 from, for example, a controller, such as controller 110. In alternative embodiments, node 416 is not connected to switches P1L and N1. For example, the gates of switches P1L and N1 may be connected to a second input, and the input signal from the controller is differential. In the illustrated embodiment, the switches of input circuit 410 are low voltage switches.

The input signal at node 412 may have a first voltage range, between voltage VinLo and voltage VinHI, such as from 0 V to 1 V, or another voltage range. Based on the input signal, input circuit 410 generates signals for output circuit 420 at nodes 416 and 418, where the signals for output circuit 420 may also have the first voltage range. In some embodiments, the signals for the output circuit 420 have a different voltage range.

In some embodiments, input circuit 410 is inverting, such that the output signal and the input signal have opposite polarity. In some embodiments, input circuit 410 is noninverting, such that the input signal and the output signal have the same polarity.

Output circuit 420 includes switches which receive an input signal at input nodes 416 and 418 from input circuit 410. In some embodiments, the switches of output circuit 420 include low voltage switches. In some embodiments, the switches of output circuit 420 include medium voltage switches. In some embodiments, the switches of output circuit 420 include high voltage switches. In some embodiments, all of the switches of output circuit 420 are high voltage switches. In the illustrated embodiment, switches N4d and N5d are low voltage switches, switches N4u and N5u are medium voltage switches, and switches Po, P1, P4, and P5 are high voltage switches.

In the illustrated embodiment, the input signal at nodes 416 and 418 may have the first voltage range, such as from 0 V to 1 V, or another voltage range. Based on the input signal at nodes 416 and 418, output circuit 420 generates signals for buffer circuit 430 at nodes 426 and 428, where the signals for buffer circuit 430 may have a second voltage range between voltage VinLO and voltage VoutHI, which is different from the first voltage range. For example, the signals for the buffer circuit 430 may have a range greater than the first voltage range, such as from 0 V to 4 V or 5 V, or another voltage range.

In some embodiments, output circuit 420 is inverting, such that the output signal and the input signal have opposite polarity. In some embodiments, output circuit 420 is noninverting, such that the input signal and the output signal have the same polarity.

Buffer circuit 430 includes switches which receive an input signal at input nodes 426 and 428 from output circuit 420. **In** some embodiments, the switches of buffer circuit 430 include low voltage switches. **In** some embodiments, the switches of buffer circuit 430 include medium voltage switches. **In** some embodiments, the switches of buffer circuit 430 include high voltage switches. **In** some embodiments, all of the switches of buffer circuit 430 are high voltage switches. **In** the illustrated embodiment, switches P3 and P2 are high voltage switches, switches N3u and N2u are medium voltage switches, and switches N3d, N3dd, N2d, and N2dd are low voltage switches.

**In the** illustrated embodiment, the P-type switches are high voltage switches, and the N-type switches are either medium or low voltage switches.

Based on the input signal at nodes 426 and 428, buffer circuit 430 generates the output signals of level shifter circuit 400 at output nodes VOUT and VOUT_N. The output signals for level shifter circuit 400 may have a third voltage range between voltage VoutLO and voltage VoutHI. In some embodiments, the output signals for the level shifter circuit 400 have a voltage range from 0 V to 5 V, or another voltage range. In some embodiments, the output signals for level shifter circuit 400 may have another voltage range which is different from the voltage range of the input signal at nodes 426 and 428.

In some embodiments, buffer circuit 430 is inverting, such that the output signal and the input signal have opposite polarity. In some embodiments, buffer circuit 430 is noninverting, such that the input signal and the output signal have the same polarity.

The following examples of configurations and relationships between various voltages may be used, for example, to ensure or maximize functionality while preventing or minimizing voltage stress or overstress of the various transistors.

Because of the structure of the architecture, medium voltage switches N2u, N3u, N4u, and N5u experience drain to source voltages which are less than a specified maximum drain to source voltages for the medium voltage N-type switches.

Because of the structure of the architecture, low voltage switches N3d, N3dd, N4d, N5d, N2d, and N2dd experience drain to source voltages which are less than a specified maximum drain to source voltages for the low voltage N-type switches.

In some embodiments, series combinations of medium and low voltage switches N3u and N3d, N4u and N4d, N5u and N5d, and N2u and N2d, experience drain to source voltages which are limited to VoutHI (e.g. 5 V) - VinHI (e.g. 1 V).

In some embodiments, high voltage switches P0, P1, P2, P3, P4, and P5 experience drain to source voltages which are up to VoutHI (e.g. 5 V) - VoutLO (e.g. 0 V). This may be appropriately less than a specified maximum drain to source voltages for the P-type switches.

This architecture is particularly advantageous when used for circuits manufactured with processing technologies in which the maximum drain to source voltage is greater for P-type switches than for N-type switches.

In some embodiments, voltage VcascN1 may be connected to or is otherwise the same as or is substantially the same as voltage VinHI. In some embodiments, voltage VcascN1 is less than voltage VinHI + Vgs threshold voltages of switches N4d and N5d to limit leakage. In some embodiments, voltage VcascN1 is less than the maximum voltage allowed for a low voltage switch + the Vgs threshold voltages of switches N4d and N5d. In some embodiments, voltage VcascN1 is greater than voltage VcascN2 - the Vgs threshold of switches N4u and N5u + the maximum voltage allowed for a medium voltage switch. In some embodiments, voltage VcascN2 is the average of voltage VoutHI and voltage VinLO. In some embodiments, voltage VcascN2 is less than voltage VinLO + the maximum voltage allowed for a medium voltage switch. In some embodiments, voltage VcascN2 is greater than voltage VoutHI - the maximum voltage allowed for a medium voltage switch.

In some embodiments, voltage VoutLO is equal to voltage VinLO. In some embodiments, voltage VoutLO is greater than voltage VinLO.

In some embodiments, the gate of switch N2dd is not connected to node 418 and is connected to node 412.

In some embodiments, the gate of switch N3dd is driven by a delay element receiving input node 316 as an input. The delay may be designed to be sufficient that the switch N3dd is not on while switch P3 is on. In some embodiments, the gate of switch N2dd is driven by a delay element receiving either node 412 or 418 as an input. The delay may be designed to be sufficient that the switch N2dd is not on while switch P2 is on.

In some embodiments, switches PoL and P1L are omitted. This has an advantage, for example, that the level shifter may be smaller and may use less power. When used, switches PoL and P1L increase speed by increasing the voltages at nodes 416 and 418. In embodiments with switches PoL and P1L omitted, leakage from voltage VinHI to voltage VoutHI through cascode switches N4u, N4d, N5u, and N5d may be avoided.

In some embodiments, switches P4 and P5 are omitted. This has an advantage, for example, that the level shifter may be smaller and may use less power. In some embodiments, using switches P4 and P5 may, for example, improve speed.

In some embodiments, one of outputs VOUT and VOUT_N is not needed, and either switches P3, N3u, N3d, and N3dd are omitted or switches P2, N2u, N2d, and N2dd are omitted, for example, to save area and improve speed.

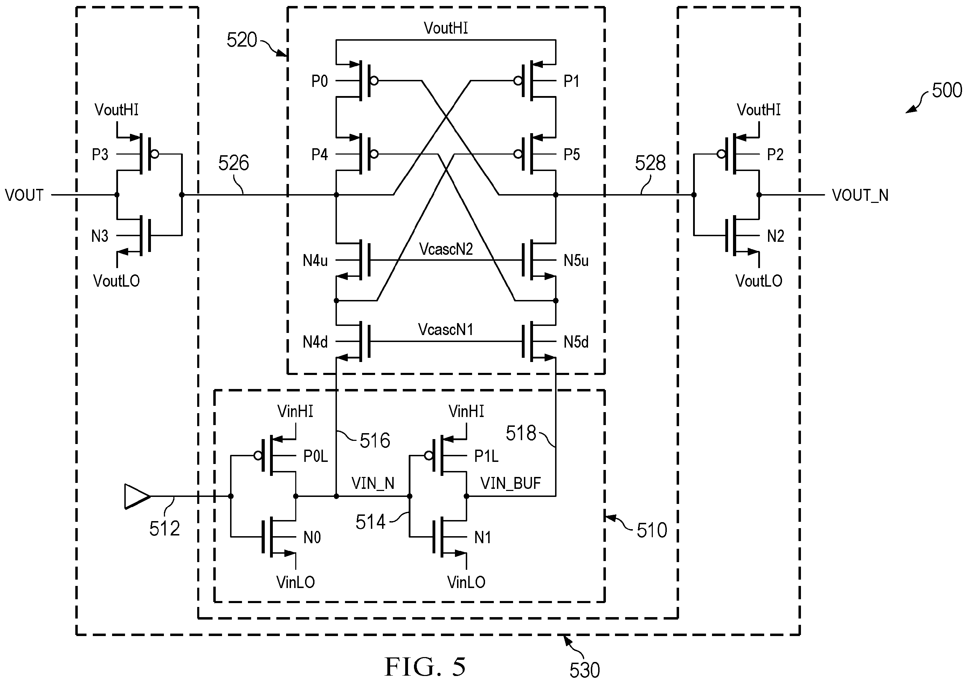

Figure 5 shows a schematic circuit diagram of a level shifter circuit 500 according to some embodiments. Level shifter circuit 500 is a nonlimiting example of level shifter circuit 200, and includes input circuit 510, output circuit 520, and buffer circuit 530. Unless otherwise specified or understood, level shifter circuit 500 has features similar or identical to those of level shifter circuits 300 and/or 400.

Input circuit 510 includes switches which receive an input signal at input node 512 from, for example, a controller, such as controller 110. In alternative embodiments, node 516 is not connected to switches P1L and N1. For example, the gates of switches P1L and N1 may be connected to a second input, and the input signal from the controller is differential. In the illustrated embodiment, the switches of input circuit 510 are low voltage switches.

The input signal at node 512 may have a first voltage range, between voltage VinLo and voltage VinHI, such as from 0 V to 1 V, or another voltage range. Based on the input signal, input circuit 510 generates signals for output circuit 520 at nodes 516 and 518, where the signals for output circuit 520 may also have the first voltage range. In some embodiments, the signals for the output circuit 520 have a different voltage range.

In some embodiments, input circuit 510 is inverting, such that the output signal and the input signal have opposite polarity. In some embodiments, input circuit 510 is noninverting, such that the input signal and the output signal have the same polarity.

Output circuit 520 includes switches which receive an input signal at input nodes 516 and 518 from input circuit 510. In some embodiments, the switches of output circuit 520 include low voltage switches. In some embodiments, the switches of output circuit 520 include medium voltage switches. In some embodiments, the switches of output circuit 520 include high voltage switches. In some embodiments, all of the switches of output circuit 520 are high voltage switches. In the illustrated embodiment, switches N4d and N5d are low voltage switches, switches N4u and N5u are medium voltage switches, and switches P0, P1, P4, and P5 are high voltage switches.

In the illustrated embodiment, the input signal at nodes 516 and 518 may have the first voltage range, such as from 0 V to 1 V, or may have another voltage range. Based on the input signal at nodes 516 and 518, output circuit 520 generates signals for buffer circuit 530 at nodes 526 and 528, where the signals for buffer circuit 530 may have a second voltage range between voltage VinLO and voltage VoutHI, which is different from the first voltage range. For example, the signals for the buffer circuit 530 may have a range greater than the first voltage range, such as from 0 V to 4 V or 5 V, or another voltage range.

In some embodiments, output circuit 520 is inverting, such that the output signal and the input signal have opposite polarity. In some embodiments, output circuit 520 is noninverting, such that the input signal and the output signal have the same polarity.

Buffer circuit 530 includes switches which receive an input signal at input nodes 526 and 528 from output circuit 520. In some embodiments, the switches of buffer circuit 530 include low voltage switches. In some embodiments, the switches of buffer circuit 530 include medium voltage switches. In some embodiments, the switches of buffer circuit 530 include high voltage switches. In some embodiments, all of the switches of buffer circuit 530 are high voltage switches. In the illustrated embodiment, switches P3, P2, N3, and N2 are high voltage switches.

Based on the input signal at nodes 526 and 528, buffer circuit 530 generates the output signals of level shifter circuit 500 at output nodes VOUT and VOUT_N. The output signals for level shifter circuit 500 may have a third voltage range between voltage VoutLO and voltage VoutHI. In some embodiments, the output signals for the level shifter circuit 500 have a voltage range from 2 V to 5 V, or another voltage range. In some embodiments, the output signals for level shifter circuit 500 may have another voltage range which is different from the voltage range of the input signal at nodes 526 and 528.

In some embodiments, buffer circuit 530 is inverting, such that the output signal and the input signal have opposite polarity. In some embodiments, buffer circuit 530 is noninverting, such that the input signal and the output signal have the same polarity.

The following examples of configurations and relationships between various voltages may be used, for example, to ensure or maximize functionality while preventing or minimizing voltage stress or overstress of the various transistors.

Because of the structure of the architecture, medium voltage switches N4u and N5u experience drain to source voltages which are less than a specified maximum drain to source voltages for the medium voltage N-type switches.

Because of the structure of the architecture, low voltage switches N4d and N5d experience drain to source voltages which are less than a specified maximum drain to source voltages for the low voltage N-type switches.

In some embodiments, series combinations of medium and low voltage switches N4u and N4d, and N2u and N2d, experience drain to source voltages which are limited to VoutHI (e.g. 5 V) - VinHI (e.g. 1 V).

In some embodiments, high voltage switches P0, P1, P2, P3, P4, and P5 experience drain to source voltages which are up to VoutHI (e.g. 5 V) - VoutLO (e.g. 0 V). This may be appropriately less than a specified maximum drain to source voltages for the P-type switches.

In some embodiments, voltage VcascN1 may be connected to or is otherwise the same as or is substantially the same as voltage VinHI. In some embodiments, voltage VcascN1 is less than voltage VinHI + Vgs threshold voltages of switches N4d and N5d to limit leakage. In some embodiments, voltage VcascN1 is less than the maximum voltage allowed for a low voltage switch + the Vgs threshold voltages of switches N4d and N5d. In some embodiments, voltage VcascN1 is greater than voltage VcascN2 - the Vgs threshold of switches N4u and N5u + the maximum voltage allowed for a medium voltage switch. In some embodiments, voltage VcascN2 is the average of voltage VoutHI and voltage VinLO. In some embodiments, voltage VcascN2 is less than voltage VinLO + the maximum voltage allowed for a medium voltage switch. In some embodiments, voltage VcascN2 is greater than voltage VoutHI - the maximum voltage allowed for a medium voltage switch.

In some embodiments, voltage VoutLO is equal to voltage VinLO. In some embodiments, voltage VoutLO is greater than voltage VinLO.

In some embodiments, switches P0L and P1L are omitted. This has an advantage, for example, that the level shifter may be smaller and may use less power. When used, switches P0L and P1L increase speed by increasing the voltages at nodes 516 and 518. In embodiments with switches P0L and P1L omitted, leakage from voltage VinHI to voltage VoutHI through cascode switches N4u, N4d, N5u, and N5d may be avoided.

In some embodiments, switches P4 and P5 are omitted. This has an advantage, for example, that the level shifter may be smaller and may use less power. In some embodiments, using switches P4 and P5 may, for example, improve speed.

In some embodiments, switches N4u and N4d are replaced with a single cascode switch, such as switch N4 of figure 3. In some embodiments, switches N5u and N5d are replaced with a single cascode switch, such as switch N5 of figure 3.

In some embodiments, one of outputs VOUT and VOUT_N is not needed, and either switches P3 and N3 are omitted or switches P2 and N2 are omitted, for example, to save area and improve speed.

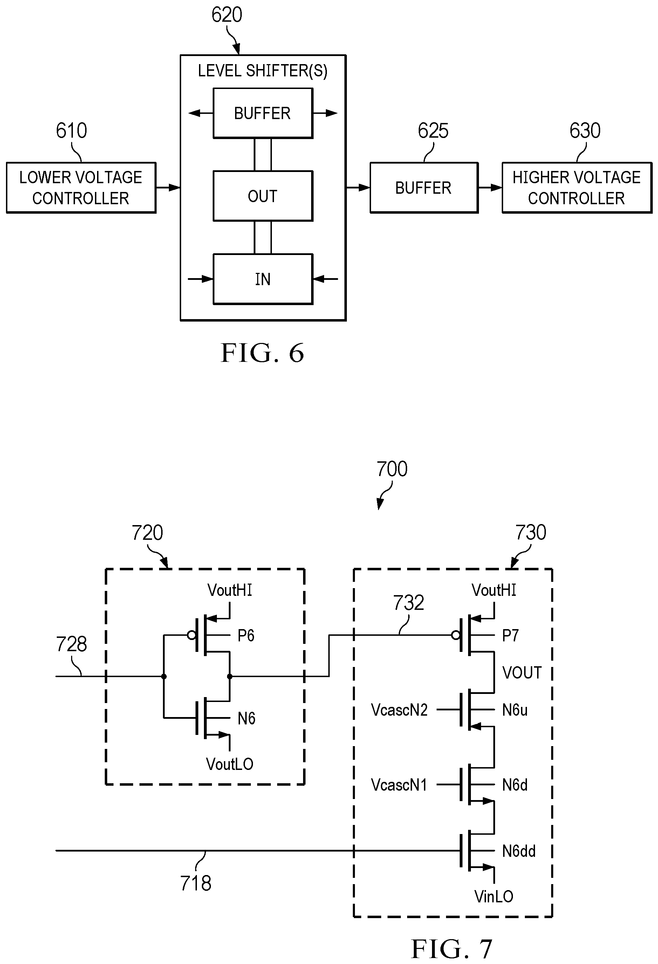

Figure 6 shows a schematic circuit diagram of an electronic system 600 according to some embodiments. Electronic system 600 includes a controller 610, level shifting circuit 620, buffer circuit 625, and controlled circuit 630.

Controller 610 generates control signals for controlled circuit 630 using, for example, low voltage switches, where the control signals generated by controller 610 have a lower level voltage range, such as from 0 V to 1 V, or another voltage range. In some embodiments, controller 610 is or includes a controller or processor for a system including an array of devices, such as a memory, a display, or an image capture device.

Controlled circuit 630 performs its functions using circuits having, for example, high voltage switches which generate signals having a higher voltage range, such as from 0 V to 5 V, or another voltage range. In addition, controlled circuit 630 generates the signals in response to input control signals having the higher voltage range. In some embodiments, controlled circuit 630 includes an array of unit cell devices, such as for an array of memory cells, an array of display cells, or an array of image capture cells.

Level shifting circuit 620 includes one or more level shifter circuits, examples of which are described in more detail elsewhere herein. For example, level shifting circuit 620 may have features similar or identical to any of the level shifting circuits discussed herein, such as those illustrated in any of figures 2-5. The level shifting circuit 620 receives the lower voltage control signals from controller 610 and generates the higher voltage control signals for buffer circuit 625.

Buffer circuit 625 is configured to buffer and/or level shift signals received from level shifting circuit 620. A non-limiting example of a single-ended buffer circuit 625 is discussed below with reference to figure 7. In some embodiments, buffer circuit 625 comprises two single-ended buffer circuits cooperatively configured to receive a differential signal from level shifting circuit 620 and to generate a corresponding differential signal for high voltage controlled circuit 630.

Figure 7 shows a schematic circuit diagram of buffer circuit 700 according to some embodiments. Buffer circuit 700 includes inverter 720 and output circuit 730.

Inverter 720 receives an input at input node 728, for example, from a level shifter circuit, such as any of level shifter circuits 200, 300, 400, and 500. For example, input node 728 may be directly or indirectly connected to an output node of the level shifter circuit. In some embodiments, the input at input node 728 for inverter 720 has a voltage range between voltage VoutLO and voltage VoutHI. Inverter 720 generates a signal at node 732 for output circuit 730, for example, having voltage range between voltage VoutLO and voltage VoutHI.

In some embodiments, the switches P6 and N6 of inverter 720 are high voltage switches.

Output circuit 730 includes switches which receive an input signal at node 732 from inverter 720. Output circuit 730 also receives an input signal at input node 718 from, for example, a level shifter circuit, such as any of level shifter circuits 200, 300, 400, and 500. For example, input node 718 may be directly or indirectly connected to a node of the level shifter circuit. For example, input node 718 may be directly or indirectly connected to any of nodes 312, 314, 316, or 318 of level shifter circuit 300, nodes 412, 416, or 418 of level shifter circuit 500, and nodes 512, 516, or 518 of level shifter circuit 500. In some embodiments, the input signal at input node 718 has a voltage range between voltage VinLO and voltage VinHI of the level shifter circuit.

In some embodiments, input node 728 is directly or indirectly connected to an output node VOUT of one of the level shifter circuits 300, 400, and 500, and input node 718 directly or indirectly connected to any of nodes 312 or 318 of level shifter circuit 300, nodes 412 or 418 of level shifter circuit 500, and nodes 512 or 518 of level shifter circuit 500. In some embodiments, input node 728 is directly or indirectly connected to an output node VOUT_N of one of the level shifter circuits 300, 400, and 500, and input node 718 directly or indirectly connected to any of nodes 314 or 316 of level shifter circuit 300, node 414 of level shifter circuit 500, and node 514 of level shifter circuit 500.

In some embodiments, the switches of output circuit 730 include low voltage switches. In some embodiments, the switches of output circuit 730 include medium voltage switches. In some embodiments, the switches of output circuit 730 include high voltage switches. In some embodiments, all of the switches of output circuit 730 are high voltage switches. In the illustrated embodiment, switches P7 is a high voltage switch, switch N6u is a medium voltage switch, and switches N6d and N6dd are low voltage switches.

Cascode switches N6u and N6d respectively receive cascode voltage signals at cascode nodes VcascN2 and VcascN1 from, for example, the level shifter circuit. For example, cascode nodes VcascN2 and VcascN1 may be respectively directly or indirectly connected to cascode nodes, such as cascode nodes VcascN2 and VcascN1 of any of level shifter circuits 200, 300, 400, and 500.

Based on the input signal at nodes 718 and 728, output circuit 730 generates the output signal of buffer circuit 700 at output node VOUT. The output signal for buffer circuit 700 may have a voltage range between voltage VinLO and voltage VoutHI. In some embodiments, the output signals for the buffer circuit 700 have a voltage range from 0 V to 5 V, or another voltage range. In some embodiments, the output signals for buffer circuit 700 may have another voltage range which is different from the voltage range of the input signals at nodes 518 and 528.

In some embodiments, output circuit 730 is inverting, such that the output signal and the input signal have opposite polarity. In some embodiments, output circuit 730 is noninverting, such that the input signal and the output signal have the same polarity.

The following examples of configurations and relationships between various voltages may be used, for example, to ensure or maximize functionality while preventing or minimizing voltage stress or overstress of the various transistors.

In some embodiments, high voltage switch P7 experiences drain to source voltages which are up to VoutHI (e.g. 5 V) - VoutLO (e.g. 0 V). This may be appropriately less than a specified maximum drain to source voltages for the P-type switch.

In some embodiments, voltage VoutLO is equal to voltage VinLO. In some embodiments, voltage VoutLO is greater than voltage VinLO.

In some embodiments, the gate of switch N6dd is driven by a delay element connected to input node 718 at an input. The delay may be designed to be sufficient that the switch N6dd is not on while switch P7 is on.

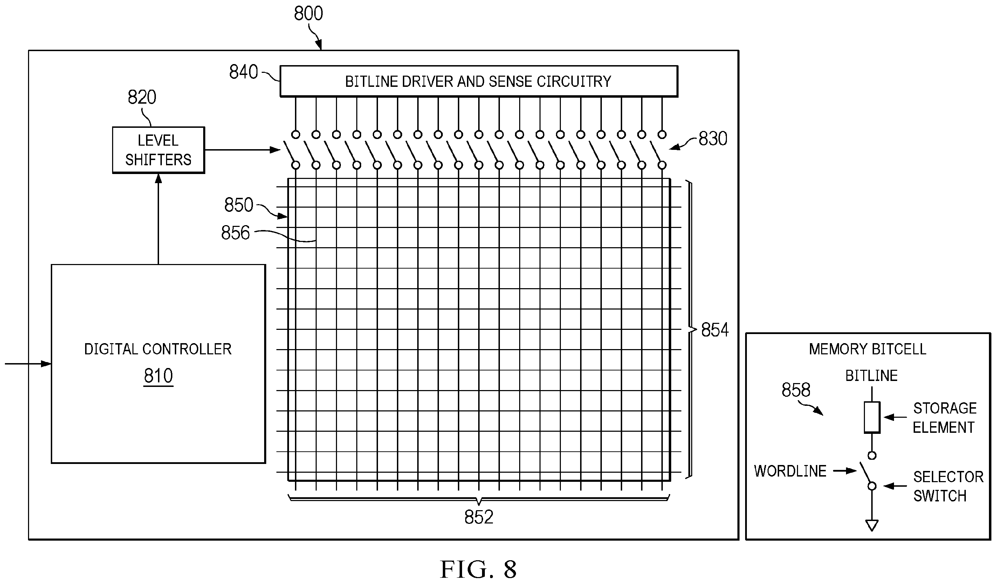

Figure 8 shows a schematic circuit diagram of an electronic system 800 having a level shifting circuit 820 according to some embodiments. In the illustrated embodiment, electronic system 800 is a memory system including a controller 810, level shifting circuit 820, and a controlled circuit, which is a switch array 830, i.e., an array of switches. Memory system also includes bitline driver and sense circuitry 840, and memory array 850. Other electronic systems may use level shifter circuits having properties similar or identical to those of level shifting circuit 820.

Memory array 850 includes an array of memory bit cells 858. The illustrated bit cell 858 is an example and is not meant to be limiting. Each bit cell 858 is located at or near an intersection 856 of a particular bit line 852 of bit lines 852 and a particular word line 854 of word lines 854.

Bit line driver and sense circuitry 840 is used to store data in those memory bit cells 858 connected thereto by the switch array 830. In addition, bit line driver and sense circuitry 840 may be used to retrieve data from those memory bit cells 858 connected thereto by the switch array 830. Which memory bit cells 858 are connected to bit line driver and sense circuitry 840 is determined by control signals generated by controller 810.

Controller 810 generates the control switches signals for switch array 830 using, for example, low voltage switches, where the control signals generated by controller 810 have a lower level voltage range, such as from 0 V to 1 V, or another voltage range.

Switch array 830 performs its switching functions using circuits having, for example, high voltage switches which generate or conduct signals having a higher voltage range, such as from 0 V to 5 V, or another voltage range. In addition, switch array 830 generates or conducts the signals in response to input control signals having the higher voltage range.

Level shifting circuit 820 includes one or more level shifter circuits, examples of which are described elsewhere herein. The level shifting circuit 820 receives the lower voltage control signals from controller 810 and generates the higher voltage control signals for switch array 830. In response to the higher voltage control signals the switches of switch array 830 selectively connect and disconnect the bit line 852 of memory array 850 to and from bit line driver and sense circuitry 840.

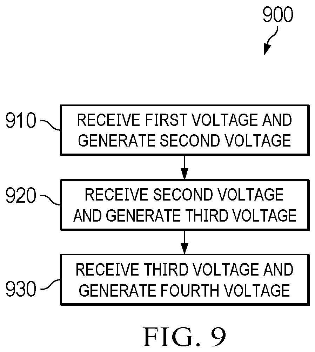

Figure 9 shows a flowchart diagram of a method 900 of using an electronic system according to some embodiments. The method 900 may be performed, for example, by an electronic system, such as electronic system 100 or 600 or by any of the level shifter circuits described herein.

At 910, a first circuit receives a first voltage and generates a second voltage. In some embodiments, the second voltage varies between a VinLO low voltage (e.g., 0 V) and a VinHI high voltage (e.g., 1 V). In some embodiments, the first circuit comprises a plurality of low voltage threshold switches. In some embodiments, the first circuit is or comprises an input circuit having features similar or identical to any of the input circuits described herein.

At 920, a second circuit receives the second voltage and generates a third voltage. In some embodiments, the third voltage varies between the VinLO low voltage and a VoutHI high voltage (e.g., 5 V).

In some embodiments, the second circuit comprises a plurality of high voltage threshold switches. In some embodiments, the second circuit comprises a plurality of medium voltage threshold switches. In some embodiments, the second circuit comprises a plurality of medium voltage threshold switches. In some embodiments, the second circuit comprises a plurality of high voltage threshold switches, a plurality of medium voltage threshold switches, and a plurality of medium voltage threshold switches.

In some embodiments, the second circuit is or comprises an output circuit having features similar or identical to any of the output circuits described herein.

At 930, a third circuit receives the third voltage generates a fourth voltage. In some embodiments, the fourth voltage varies between a VinLO low voltage (e.g., 0 V) and the VoutHI high voltage.

In some embodiments, the third circuit comprises a plurality of high voltage threshold switches. In some embodiments, the third circuit comprises a plurality of medium voltage threshold switches. In some embodiments, the third circuit comprises a plurality of medium voltage threshold switches. In some embodiments, the third circuit comprises a plurality of high voltage threshold switches, a plurality of medium voltage threshold switches, and a plurality of medium voltage threshold switches.

Examples of the present invention are summarized here. Other examples can also be understood from the entirety of the specification and the claims filed herein.

Example 1 One embodiment is a level shifter circuit, including an input circuit including a plurality of low voltage threshold switches and configured to receive an input voltage and to generate a second voltage, where the second voltage varies between a first low voltage and a first high voltage; an output circuit including a first plurality of high voltage switches and configured to receive the second voltage and to generate a third voltage, where the third voltage varies between the first low voltage and a second high voltage; and a buffer circuit , the buffer circuit being configured to receive the third voltage and to generate a buffer circuit output voltage, where the buffer circuit output voltage varies between a second low voltage and the second high voltage.

Example 2 The level shifter circuit of any of the preceding examples, where the second high voltage is greater than the first low voltage, and where the first high voltage is less than the second high voltage.

Example 3 The level shifter circuit of any of the preceding examples, where the second low voltage is greater than the first low voltage.

Example 4 The level shifter circuit of any of the preceding examples, where the second low voltage is equal to the first low voltage.

Example 5 The level shifter circuit of any of the preceding examples, where the output circuit further includes a second plurality of low voltage switches.

Example 6 The level shifter circuit of any of the preceding examples, where the first high voltage is greater than the first low voltage and is less than the second high voltage.

Example 7 The level shifter circuit of any of the preceding examples, where the buffer circuit includes a plurality of medium voltage switches.

Example 8 The level shifter circuit of any of the preceding examples, where each P type switch of the output circuit and the buffer circuit is a high voltage switch, and where each N type switch of the output circuit and the buffer circuit is either a medium voltage switch or a low voltage switch.

Example 9 Another embodiment is an array circuit, including an array of devices, where a plurality of devices of the array each include at least one high voltage switch; a controller configured to generate a plurality of first control signals for controlling the array of devices; and an array of level shifters, each level shifter configured to receive one of the first control signals from the controller as an input voltage, to generate one of a plurality of second control signals as a level shifter output voltage, and to provide the level shifter output voltage to one of the devices of the array of devices, where the level shifters each include an input circuit including a plurality of low voltage threshold switches and configured to generate a second voltage, where the second voltage varies between a first low voltage and a first high voltage; an output circuit including a first plurality of high voltage switches and configured to receive the second voltage and to generate a third voltage, where the third voltage varies between the first low voltage and a second high voltage; and a buffer circuit , the buffer circuit configured to receive the third voltage and to generate a buffer circuit output voltage, where the buffer circuit output voltage varies between a second low voltage and the second high voltage.

Example 10 The array circuit of any of the preceding examples, where the second high voltage is greater than the first low voltage, and where the first high voltage is less than the second high voltage.

Example 11 The array circuit of any of the preceding examples, where the second low voltage is greater than the first low voltage.

Example 12 The array circuit of any of the preceding examples, where the second low voltage is equal to the first low voltage.

Example 13 The array circuit of any of the preceding examples, where the output circuit includes a second plurality of low voltage switches.

Example 14 The array circuit of any of the preceding examples, where the first high voltage is greater than the first low voltage and is less than the second high voltage.

Example 15 The array circuit of any of the preceding examples, where the buffer circuit includes a plurality of medium voltage switches.

Example 16 The array circuit of any of the preceding examples, where each P type switch of the output circuit and the buffer circuit is a high voltage switch, and where each N type switch of the output circuit and the buffer circuit is either a medium voltage switch or a low voltage switch.

Example 17 Another embodiment is a method of using a level shifter circuit, the method including with an input circuit including a plurality of low voltage threshold switches receiving an input voltage, and generating a second voltage based in part on the input voltage, where the second voltage varies between a first low voltage and a first high voltage; with an output circuit including a plurality of high voltage switches receiving the second voltage, and generating a third voltage based on the second voltage, where the third voltage varies between the first low voltage and a second high voltage; and with a buffer circuit receiving the third voltage, and generating an output voltage based on the third voltage, where the output voltage varies between a second low voltage and the second high voltage.

Example 18 The method of any of the preceding examples, where the second high voltage is greater than the first low voltage, and where the first high voltage is less than the second high voltage.

Example 19 The method of any of the preceding examples, where the second low voltage is greater than the first low voltage.

Example 20 The method of any of the preceding examples, where the second low voltage is equal to the first low voltage.

## Claims

1. A level shifter circuit, comprising:
an input circuit comprising a plurality of low voltage threshold switches and configured to receive an input voltage and to generate a second voltage, wherein the second voltage varies between a first low voltage and a first high voltage;
an output circuit comprising a first plurality of high voltage switches and configured to receive the second voltage and to generate a third voltage, wherein the third voltage varies between the first low voltage and a second high voltage; and
a buffer circuit , the buffer circuit being configured to receive the third voltage and to generate a buffer circuit output voltage, wherein the buffer circuit output voltage varies between a second low voltage and the second high voltage.

2. The level shifter circuit of claim 1, wherein the second high voltage is greater than the first low voltage, and wherein the first high voltage is less than the second high voltage.

3. The level shifter circuit of claim 1, wherein the second low voltage is greater than the first low voltage.

4. The level shifter circuit of claim 1, wherein the second low voltage is equal to the first low voltage.

5. The level shifter circuit of claim 1, wherein the output circuit further comprises a second plurality of low voltage switches.

6. The level shifter circuit of claim 1, wherein the first high voltage is greater than the first low voltage and is less than the second high voltage.

7. The level shifter circuit of claim 1, wherein the buffer circuit comprises a plurality of medium voltage switches.

8. The level shifter circuit of claim 1, wherein each P type switch of the output circuit and the buffer circuit is a high voltage switch, and wherein each N type switch of the output circuit and the buffer circuit is either a medium voltage switch or a low voltage switch.

9. An array circuit, comprising:
an array of devices, wherein a plurality of devices of the array each comprise at least one high voltage switch;
a controller configured to generate a plurality of first control signals for controlling the array of devices; and
an array of level shifters, each level shifter configured to receive one of the first control signals from the controller as an input voltage, to generate one of a plurality of second control signals as a level shifter output voltage, and to provide the level shifter output voltage to one of the devices of the array of devices, wherein the level shifters each comprise:
an input circuit comprising a plurality of low voltage threshold switches and configured to generate a second voltage, wherein the second voltage varies between a first low voltage and a first high voltage;
an output circuit comprising a first plurality of high voltage switches and configured to receive the second voltage and to generate a third voltage, wherein the third voltage varies between the first low voltage and a second high voltage; and
a buffer circuit , the buffer circuit configured to receive the third voltage and to generate a buffer circuit output voltage, wherein the buffer circuit output voltage varies between a second low voltage and the second high voltage.

10. The array circuit of claim 9, wherein the second high voltage is greater than the first low voltage, and wherein the first high voltage is less than the second high voltage.

11. The array circuit of claim 9, wherein the second low voltage is greater than the first low voltage.

12. The array circuit of claim 9, wherein the second low voltage is equal to the first low voltage.

13. The array circuit of claim 9, wherein the output circuit comprises a second plurality of low voltage switches.

14. The array circuit of claim 9, wherein the first high voltage is greater than the first low voltage and is less than the second high voltage.

15. The array circuit of claim 9, wherein the buffer circuit comprises a plurality of medium voltage switches.

16. The array circuit of claim 9, wherein each P type switch of the output circuit and the buffer circuit is a high voltage switch, and wherein each N type switch of the output circuit and the buffer circuit is either a medium voltage switch or a low voltage switch.

17. A method of using a level shifter circuit, the method comprising:
with an input circuit comprising a plurality of low voltage threshold switches:
receiving an input voltage, and
generating a second voltage based in part on the input voltage, wherein the second voltage varies between a first low voltage and a first high voltage;
with an output circuit comprising a plurality of high voltage switches:
receiving the second voltage, and
generating a third voltage based on the second voltage, wherein the third voltage varies between the first low voltage and a second high voltage; and
with a buffer circuit:
receiving the third voltage, and
generating an output voltage based on the third voltage, wherein the output voltage varies between a second low voltage and the second high voltage.

18. The method of claim 17, wherein the second high voltage is greater than the first low voltage, and wherein the first high voltage is less than the second high voltage.

19. The method of claim 17, wherein the second low voltage is greater than the first low voltage.

20. The method of claim 17, wherein the second low voltage is equal to the first low voltage.
